# EUROPEAN PATENT APPLICATION

(11) **EP 4 803 655 A1**
(43) Date of publication of application: **09.09.2026**
(21) Application number: 25782122.3
(22) Date of filing: 18.03.2025
(51) Int. Cl.: C23C 26/00, B05D 1/26, B05D 3/10, B05D 5/00, B05D 7/00, B32B 3/30, B32B 15/08, C09K 3/00, H05K 3/28

(54) **SURFACE TREATMENT AGENT, METHOD FOR PRODUCING FILM-FORMING SUBSTRATE, AND FILM-FORMING SUBSTRATE**

(30) Priority: 02.04.2024 JP 2024059360
(71) Applicant: MEC COMPANY., LTD., Amagasaki-shi, Hyogo 660-0822 (JP)
(72) Inventor: Ogushi Ryo, Amagasaki-shi, Hyogo 660-0822 (JP)
(74) Representative: dompatent
(86) International application number: PCT/JP2025/010393
(87) International publication number: WO 2025/211158

(57) **Abstract**

An object of the present invention is to provide a surface treatment agent, a method for producing a film-forming substrate, and a film-forming substrate, which are capable of sufficiently improving coating properties with respect to a resin composition on both a metal surface and a resin surface when a film of the resin composition is formed on a substrate surface.

The present invention provides a surface treatment agent for treating a substrate surface including a metal surface and a resin surface, the surface treatment agent containing 0.001 mass% or more and 1.2 mass% or less of an amine compound that is at least one selected from the group consisting of an alkylamine having an alkyl group having 19 to 24 carbon atoms, an alkenylamine having an alkenyl group having 18 to 22 carbon atoms, and salts thereof.

## Description

### Technical Field

The present invention relates to a surface treatment agent, a method for producing a film-forming substrate, and a film-forming substrate.

### Background Art

A film-forming substrate in which a film of a curable resin composition such as a solder resist or an etching resist is formed on a surface of a metal substrate is used, for example, as a printed wiring board that is covered with a solder resist while leaving copper openings for electrical connection by soldering. Such a film-forming substrate is generally produced by disposing a resin composition at desired locations on a surface of a metal substrate by printing using a screen plate or by a photo method involving exposure and development; however, in recent years, attention has been paid to a method for forming a film by drawing a resin composition using an inkjet method.

The inkjet method has advantages in that no plate or photomask is required, the number of steps is small, and a film is easily formed simply and only at necessary portions.

On the other hand, in the inkjet method, since it is necessary to use a solder resist or the like having a lower viscosity than conventional one, there is a problem in that bleeding after application tends to occur. As a technique for reducing such bleeding, for example, as described in Patent Documents 1 to 4, a surface treatment has been proposed in which a surface treatment agent is brought into contact with a metal surface on a substrate in order to adjust wettability.

However, in these conventional surface treatment techniques, even when the wettability of a metal surface on a substrate can be improved, modification of a resin surface is insufficient in cases where resin surfaces are present together on the substrate. In general, a resin surface such as an insulating resin surface may be present on a substrate surface, in addition to a metal surface, and it is required to improve coating properties with respect to a solder resist on both the metal surface and the resin surface.

### Documents for prior art

### Patent Documents

Patent Document 1: JP 2015-192963 A
Patent Document 2: WO 2016/111035 A
Patent Document 3: WO 2016/111036 A
Patent Document 4: WO 2019/082681 A

### Summary of Invention

### Technical Problem

The present invention has been made in view of the above-described problems of the conventional techniques, and an object of the present invention is to provide a surface treatment agent, a method for producing a film-forming substrate, and a film-forming substrate, which are capable of sufficiently improving coating properties with respect to a resin composition on both a metal surface and a resin surface when a film of the resin composition is formed on a substrate surface.

### Solution to Problem

A surface treatment agent of the present invention is a surface treatment agent for treating a substrate surface including a metal surface and a resin surface, the surface treatment agent containing 0.001 mass% or more and 1.2 mass% or less of an amine compound that is at least one selected from the group consisting of an alkylamine having an alkyl group having 19 to 24 carbon atoms, an alkenylamine having an alkenyl group having 18 to 22 carbon atoms, and salts thereof.

In the surface treatment agent of the present invention, the amine compound may be at least one selected from the group consisting of aminononadecane, arachidylamine, henicosylamine, behenylamine, tricosylamine, tetracosylamine, and oleylamine.

The surface treatment agent of the present invention may have a pH of 4.0 or more and a pH of 14 or less.

A method for producing a film-forming substrate of the present invention is a method for producing a film-forming substrate in which a film of a resin composition is formed on a substrate surface, the method including: a surface treatment step of bringing a surface treatment agent into contact with a substrate surface including a metal surface and a resin surface to perform surface treatment so that contact angles of the metal surface and the resin surface with respect to dipropylene glycol are 35° or more and 100° or less; and a film-forming step of forming a film of a resin composition on the surface-treated substrate surface by an inkjet method.

In the method for producing a film-forming substrate of the present invention, the surface treatment agent may contain 0.001 mass% or more and 1.2 mass% or less of an amine compound that is at least one selected from the group consisting of an alkylamine having an alkyl group having 19 to 24 carbon atoms, an alkenylamine having an alkenyl group having 18 to 22 carbon atoms, and salts thereof.

In the method for producing a film-forming substrate of the present invention, in the film-forming step, a film may be formed by an inkjet method using a resin composition that is cured by heating, ultraviolet irradiation, or light irradiation.

The method for producing a film-forming substrate of the present invention may further include, prior to the surface treatment step, an etching step of etching the substrate surface with a micro-etching agent.

In the method for producing a film-forming substrate of the present invention, in the etching step, the metal surface may be etched so as to have a surface roughness (Ra) of 0.1 µm or more and 0.8 µm or less.

In the method for producing a film-forming substrate of the present invention, the surface treatment agent may have a pH of 4.0 or more and a pH of 14 or less.

A film-forming substrate of the present invention is a film-forming substrate including a substrate surface on which a film of a resin composition is formed, in which the substrate surface includes a metal surface and a resin surface, contact angles of the metal surface and the resin surface with respect to dipropylene glycol are 35° or more and 100° or less, and a surface roughness (Ra) of the metal surface is 0.1 µm or more and 0.8 µm or less.

In the film-forming substrate of the present invention, the resin surface may include at least one resin selected from the group consisting of a polyimide resin, an epoxy resin, a polyethylene terephthalate resin, a polypropylene resin, a polyvinyl chloride resin, a polyolefin resin, a polyurethane resin, and a polyacetal resin.

In the film-forming substrate of the present invention, the resin composition may be cured by heating, ultraviolet irradiation, or light irradiation.

### Effects of Invention

According to the present invention, when a film of a resin composition is formed on a substrate surface, coating properties of both a metal surface and a resin surface with respect to the resin composition can be sufficiently improved.

### Description of Embodiments

Hereinafter, embodiments of a surface treatment agent, a method for producing a film-forming substrate (hereinafter, also simply referred to as a production method), and a film-forming substrate of the present invention will be described.

### (First Embodiment: Surface Treatment Agent)

A surface treatment agent of the present embodiment is a surface treatment agent for treating a substrate surface including a metal surface and a resin surface, the surface treatment agent containing 0.001 mass% or more and 1.2 mass% or less of an amine compound that is at least one selected from the group consisting of an alkylamine having an alkyl group having 19 to 24 carbon atoms, an alkenylamine having an alkyl group having 18 to 22 carbon atoms, and salts thereof.

With the surface treatment agent of the present embodiment, by treating a surface of a substrate including a metal surface and a resin surface, the treated surface can be adjusted to a desired contact angle as described below.

### <Substrate>

The substrate to be treated with the surface treatment agent of the present embodiment is not particularly limited as long as it includes a metal surface and a resin surface, and examples thereof include circuit boards used for printed wiring boards, and some or all of various other electronic and electrical devices, medical devices, vehicle-mounted devices, automobile parts, and parts for marine equipment.

The metal constituting the metal surface is not particularly limited, and examples thereof include copper, tin, stainless steel, aluminum, nickel, titanium, and alloys thereof.

The resin constituting the resin surface is not particularly limited, and examples thereof include at least one resin selected from the group consisting of a polyimide resin, an epoxy resin, a polyethylene terephthalate resin, a polypropylene resin, a polyvinyl chloride resin, a polyolefin resin, a polyurethane resin, and a polyacetal resin.

The epoxy resin is a resin that is widely used in FR-4 substrates, which are materials for circuit boards used for printed wiring boards. When the surface treatment agent of the present embodiment is used for a circuit board composed of a substrate using an epoxy resin (such as an FR-4 substrate), the metal portion and the epoxy resin portion of the FR-4 substrate constitute a metal surface and a resin surface present on the substrate surface, and the surface treatment agent of the present embodiment is brought into contact with both surfaces, thereby allowing surface treatment to be performed on both surfaces.

### <Amine Compound>

The surface treatment agent of the present embodiment contains 0.001 mass% or more and 1.2 mass% or less of an amine compound that is at least one selected from the group consisting of an alkylamine having an alkyl group having 19 to 24 carbon atoms (hereinafter, also simply referred to as an alkylamine), an alkenylamine having an alkenyl group having 18 to 22 carbon atoms (hereinafter, also simply referred to as an alkenylamine), and salts thereof.

In the present embodiment, the alkylamine and the alkenylamine refer to aliphatic primary amines, which are amine compounds selected from the group consisting of an alkyl group or an alkenyl group each having an aliphatic hydrocarbon group constituting the aliphatic primary amine and having the respective numbers of carbon atoms described above.

Examples of the alkylamine include aminononadecane (nonadecylamine) (having 19 carbon atoms), arachidylamine (eicosylamine) (having 20 carbon atoms), henicosylamine (having 21 carbon atoms), behenylamine (having 22 carbon atoms), tricosylamine (having 23 carbon atoms), and tetracosylamine (having 24 carbon atoms).

Examples of the alkenylamine include oleylamine (18 carbon atoms) and cis-13-docosenamide (22 carbon atoms).

Examples of salts of the alkylamine and the alkenylamine include organic acid salts and inorganic acid salts of the alkylamine, and organic acid salts and inorganic acid salts of the alkenylamine.

These amine compounds may be used alone or in combination of two or more kinds.

A content of the amine compound in the surface treatment agent is 0.001 mass% or more and 1.2 mass% or less, 0.003 mass% or more and 1.2 mass% or less, 0.005 mass% or more and 1.0 mass% or less, or 0.01 mass% or more and 0.3 mass% or less.

When the content is in such a range, coating properties of both the metal surface and the resin surface with respect to the resin composition can be improved.

A pH of the surface treatment agent of the present embodiment is not particularly limited, and examples thereof include a pH of 4.0 or more and a pH of 14 or less, a pH of 5.0 or more and a pH of 13 or less, or a pH of 6.0 or more and a pH of 12 or less. When the surface treatment agent has a pH within the above range, it is preferable because adjustment to the above-described desired contact angle range is easily adjusted.

The optimal pH of the surface treatment agent can be appropriately selected depending on the type of the amine compound and the type of the resin composition forming the film; however, for example, when the amine compound contained in the surface treatment agent is an alkenylamine, the pH is preferably a pH of 4.0 or more and a pH of 14 or less. When the amine compound contained in the surface treatment agent is an alkylamine, the pH is preferably a pH of 5.0 or more and a pH of 11.0 or less, or a pH of 6.0 or more and a pH of 10 or less.

The pH of the surface treatment agent can be adjusted by blending the above-described amine compound and other known pH adjusting agents. The pH adjusting agent is not particularly limited, and examples thereof include hydrochloric acid, sulfuric acid, acetic acid, sodium hydroxide, ammonia, ethanolamine, or salts thereof (for example, sodium acetate), acetate buffer solutions, phosphate buffer solutions, citrate buffer solutions, citrate-phosphate buffer solutions, borate buffer solutions, and Good's buffers, commonly used buffering agents, chelating agents, and amino acids used for pH adjustment.

By surface-treating a metal surface and a resin surface using the surface treatment agent of the present embodiment, contact angles of both surfaces can be easily adjusted to a desired range. Here, the desired contact angle range refers to a range in which contact angles of both surfaces with respect to dipropylene glycol fall within a predetermined range.

Examples of the desired contact angle range include ranges in which the contact angles of both the metal surface and the resin surface with respect to dipropylene glycol are 35° or more and 100° or less, 36° or more and 95° or less, or 36° or more and 90° or less.

When contact angles of both the metal surface and the resin surface with respect to dipropylene glycol are within the above-described ranges, coating properties of the resin composition are not impaired, and bleeding can be more easily suppressed.

More specifically, examples of the contact angle of the metal surface with respect to dipropylene glycol include 35° or more and 100° or less, 36° or more and 95° or less, or 37° or more and 90° or less.

Examples of the contact angle of the resin surface with respect to dipropylene glycol include 35° or more and 100° or less, 37° or more and 75° or less, or 40° or more and 70° or less.

In the present embodiment, the reason for evaluating coating properties of a resin composition by setting the contact angle with respect to dipropylene glycol within a specific range is as follows.

Conventionally, when evaluating coating properties such as adhesiveness and tendency to bleed with respect to a specific substance on a surface of a specific material, a contact angle with respect to the substance is measured. However, in such a case, it is necessary to obtain the specific resin composition and perform the measurement, and therefore measurement is difficult for compositions that are difficult to obtain. In addition, it is necessary to perform measurement for each resin composition, and there is a drawback in that evaluation of coating properties for a large number of resin compositions is time-consuming.

When a resin composition, particularly a resin composition that is cured by heating, ultraviolet irradiation, or light irradiation, such as etching resist inks and solder resist inks described below, is applied to a circuit board or the like in an uncured state to form a film, it is required to adjust the contact angle of the substrate surface to an appropriate range with respect to the resin composition in the uncured state (that is, the state in which the resin composition is actually applied). However, obtaining a wide variety of products, measuring contact angles for all of them, and selecting a resin composition suitable for a specific substrate are extremely complicated.

On the other hand, JIS R3257 "Test method for wettability of substrate glass surfaces" describes a method for evaluating wettability of a substrate glass surface by measuring a contact angle using distilled water. However, since distilled water and a resin composition differ greatly in physical properties, a contact angle measured using distilled water is not necessarily appropriate as an evaluation of adhesiveness, tendency to bleed, or the like with respect to the resin composition.

From this viewpoint, as a result of examining a measurement substance that can be substituted for a resin composition, particularly a curable resin composition such as a solder resist that is suitable for use with the surface treatment agent of the present embodiment, it was found that the free energy of dipropylene glycol is relatively close to that of the curable resin composition and further has correlation with contact angles obtained when various curable resin compositions are used, and thus dipropylene glycol was found to be optimal for measurement of the contact angle in the present embodiment.

Accordingly, the contact angle as referred to in the present embodiment means a value measured by replacing distilled water with dipropylene glycol in the static drop method described in JIS R3257 "Test method for wettability of substrate glass surfaces". Specifically, it means a value measured by a method shown in Examples described below.

The surface treatment agent of the present embodiment may contain, in addition to the amine compound, other optional components such as an antifoaming agent, a rust inhibitor, and a solvent.

The surface treatment agent of the present embodiment is preferably a solution obtained by dissolving the amine compound and other components in water or other known solvents.

### (Second Embodiment: Method for Producing Film-Forming Substrate)

A method for producing a film-forming substrate of the present embodiment is a method for producing a film-forming substrate in which a film of a resin composition is formed on a substrate surface, the method including: a surface treatment step of bringing a surface treatment agent into contact with a substrate surface including a metal surface and a resin surface to perform surface treatment so that contact angles of the metal surface and the resin surface with respect to dipropylene glycol are 35° or more and 100° or less; and a film-forming step of forming a film of a resin composition on the surface-treated substrate surface by an inkjet method.

### <Film-Forming Substrate>

The film-forming substrate produced by the production method of the present embodiment is not particularly limited, as long as it is a substrate similar to the substrate in the first embodiment and has a film of a resin composition formed on a surface thereof by an inkjet method.

As the metal constituting the metal surface of the film-forming substrate, metals similar to those constituting the metal surface of the substrate in the first embodiment are exemplified.

As the resin constituting the resin surface of the film-forming substrate, resins similar to those constituting the resin surface of the substrate in the first embodiment are exemplified.

Both the metal and the resin are not limited to the examples described above.

The production method of the present embodiment is particularly suitable, for example, for producing a circuit board in which a solder resist is formed as a film on a substrate having a conductor surface (metal surface) composed of a metal containing copper, such as copper or a copper alloy (hereinafter, simply referred to as copper), and a resin surface serving as an insulator.

### <Etching Step>

The production method of the present embodiment may optionally include, prior to the surface treatment step, an etching step of etching the substrate surface using a micro-etching agent.

The micro-etching agent used in the etching step refers to an etching agent that slightly etches (micro-etches) a metal surface by being brought into contact with the metal surface to form fine irregularities on the metal surface.

The micro-etching agent used in the present embodiment is not particularly limited as long as it is capable of micro-etching the metal constituting the metal surface. For example, when the metal is copper, examples of the micro-etching agent include known micro-etching agents for copper, specifically organic acid-based etching agents, sulfuric acid-hydrogen peroxide-based etching agents, and persulfate-based etching agents.

Examples of a preferred micro-etching agent include organic acid-based micro-etching agents. Examples thereof include commercially available micro-etching agents such as aqueous solutions containing an organic acid, cupric ions, halide ions, amino group-containing compounds, and polymers.

In the etching step, a micro-etching agent is brought into contact with a metal surface to etch the metal surface, thereby forming fine irregularities on the surface.

By forming such fine irregularities, adhesion between the metal surface and the resin composition is improved.

The treatment conditions in the etching step, that is, treatment time, temperature of the micro-etching agent during treatment, and treatment methods such as spray treatment or immersion treatment, can be appropriately adjusted.

In the present embodiment, since a resin surface is also present on the substrate surface, the resin surface may also be brought into contact with the etching solution simultaneously in the etching step, or a resist or the like may be provided on the resin surface so as not to bring the resin surface into contact with the etching solution.

In the etching step, the metal surface is treated, for example, so that a surface roughness (Ra) is 0.1 µm or more and 0.8 µm or less, or 0.3 µm or more and 0.7 µm or less. By performing the treatment so that the surface roughness falls within such a range, adhesion between the metal surface and the resin composition is improved after the subsequent surface treatment step, and bleeding of the resin composition can be suppressed, thereby facilitating improvement in coating properties.

The surface roughness (Ra) as referred to in the present embodiment means an arithmetic average roughness measured in accordance with JIS B 0601 (2013).

The etching amount in the etching step as determined by a gravimetric method is preferably appropriately adjusted so as to achieve the surface roughness, and examples thereof include about 0.5 µm or more and 2.0 µm or less, or about 0.7 µm or more and 1.5 µm or less.

By setting the etching amount within the above range, it is easy to achieve an appropriate surface roughness, and therefore, after the subsequent surface treatment step, adhesion between the metal surface and the resin composition can be more easily improved.

By performing the etching step, adhesion between the resin composition and both the metal surface and the resin surface can be sufficiently improved, and at the same time, an increase in bleeding that tends to occur due to roughening of the metal surface after the etching step can be suppressed by performing the surface treatment step. Accordingly, both a bleeding suppression effect of the resin composition and adhesion between the resin composition and the metal surface and the resin surface can be sufficiently improved.

### <Surface Treatment Step>

The production method of the present embodiment includes a surface treatment step of bringing a surface treatment agent into contact with a substrate surface including a metal surface and a resin surface, thereby surface-treating the metal surface and the resin surface so that contact angles of the metal surface and the resin surface with respect to dipropylene glycol are 35° or more and 100° or less.

In the surface treatment step of the present embodiment, when the etching step is performed, treatment is performed using a surface treatment agent capable of adjusting contact angles of the micro-etched metal surface and resin surface as described above.

The surface treatment agent that can be used in the present embodiment is not particularly limited, as long as it is capable of adjusting the metal surface and the resin surface to the above-described contact angle ranges; however, when the surface treatment agent is the surface treatment agent of the present embodiment as described in the first embodiment, the effects of the production method of the present embodiment can be further enhanced.

Examples of the surface treatment agent that can be used in the present embodiment include, in addition to the surface treatment agent of the first embodiment described above, solutions containing, as an active ingredient, for example, an anionic surfactant, a nonionic surfactant, a cationic surfactant, or an amphoteric surfactant solution.

The active ingredients of the surface treatment agent may be used alone or in combination of two or more kinds.

The surface treatment agent may further contain, in addition to the active ingredient described above, other optional components such as an antifoaming agent, a rust inhibitor, and a solvent.

The surface treatment agent is preferably a solution obtained by dissolving the active ingredient and other components in water or other known solvents.

In the surface treatment step of the present embodiment, known means may be used as treatment means.

For example, the means for bringing the surface treatment agent into contact with a metal substrate surface is not particularly limited, and examples thereof include surface treatment means with a known liquid agent such as immersion and spraying.

In addition, the temperature of the surface treatment agent is not particularly limited, and examples thereof include 20°C or higher and 40°C or lower, or 25°C or higher and 35°C or lower.

Furthermore, the treatment time with the surface treatment agent (the contact time between the surface treatment agent and the metal substrate) is not particularly limited, and examples thereof include 10 seconds or longer and 2 minutes or shorter, or 30 seconds or longer and 1 minute or shorter.

After the surface treatment, the metal surface and the resin surface are surface-treated so that contact angles of both the metal surface and the resin surface with respect to dipropylene glycol are 35° or more and 100° or less, 36° or more and 95° or less, or 36° or more and 90° or less.

When contact angles of both the metal surface and the resin surface with respect to dipropylene glycol are within the above-described ranges, bleeding can be more easily suppressed while maintaining adhesion without impairing coating properties of the resin composition.

More specifically, examples of the contact angle of the metal surface with respect to dipropylene glycol include 35° or more and 100° or less, 36° or more and 95° or less, or 37° or more and 70° or less.

Examples of the contact angle of the resin surface with respect to dipropylene glycol include 35° or more and 100° or less, 37° or more and 75° or less, or 40° or more and 70° or less.

In addition, when a micro-etching step is performed prior to the surface treatment step, examples of the contact angle of the micro-etched metal surface with respect to dipropylene glycol include 35° or more and 100° or less, 40° or more and 95° or less, or 45° or more and 90° or less.

When the production method of the present embodiment is adopted in the manufacture of a circuit board, by setting contact angles of a metal surface serving as a conductor surface and a resin surface serving as an insulator with respect to dipropylene glycol within the above-described ranges, bleeding and the like can be suppressed when a curable resin such as an etching resist or a solder resist is subsequently formed as a film of a resin composition in a film-forming step.

### <Film-Forming Step>

The production method of the present embodiment includes a film-forming step of forming a film of a resin composition on a surface-treated metal substrate surface by an inkjet method.

Examples of the resin composition used in the film-forming step of the present embodiment include curable resin compositions that are cured by heating, ultraviolet irradiation, or light irradiation, such as etching resist inks and solder resist inks.

The etching resist ink and the solder resist ink can be appropriately selected from known ones; however, these inks are preferably adjusted to have a viscosity suitable for application by an inkjet method.

For example, as the etching resist ink, a resin composition that is cured by ultraviolet irradiation after application and is strippable with an alkaline aqueous solution is desirable, and specific examples include those containing a carboxyl group-containing monomer, a monofunctional monomer, a polyfunctional monomer, a photopolymerization initiator, and other optional components.

As the solder resist ink, a resin composition that is curable by heating, ultraviolet irradiation, or light irradiation and has heat resistance after curing is preferable, and specific examples include those containing, in addition to combinations of various monomers used for the etching resist ink, curing agents such as epoxy compounds and isocyanate compounds, and various optional components.

In the film-forming step, a known inkjet device is used to draw a resin composition in accordance with a desired pattern on a metal surface and/or a resin surface that is subjected to etching treatment and surface treatment. For example, the production method of the present embodiment can be applied to cases where a solder resist is applied to the outermost layer of a printed wiring board, or where an etching resist or a plating resist is applied to an inner layer.

In the production method of the present embodiment, another treatment step may be further performed after the film-forming step. For example, after forming a solder resist film in the film-forming step, a plating step of plating a metal surface exposed from an opening of the solder resist may be performed.

In this case, by performing the etching step and the surface treatment step as described above, adhesion of the resin composition such as the solder resist is improved, and penetration of a plating solution can be suppressed.

In the production method of the present embodiment, known treatment steps such as a cleaning step and a drying step may be performed between the etching step, the surface treatment step, and the film-forming step.

### (Third Embodiment: Film-Forming Substrate)

Next, the film-forming substrate of the present embodiment will be described. The film-forming substrate of the present embodiment is not limited to one produced by the method for producing a film-forming substrate of the present embodiment described above and/or by using the surface treatment agent of the present embodiment; however, the film-forming substrate may be produced by the production method of the present embodiment and/or by using the surface treatment agent of the present embodiment.

The film-forming substrate of the present embodiment is a film-forming substrate in which a film of a resin composition is formed on a metal substrate surface, and a contact angle of the metal substrate surface is 35° or more and 100° or less and a surface roughness (Ra) is 0.1 µm or more and 0.8 µm or less.

The film-forming substrate of the present embodiment is a substrate in which bleeding of the resin composition can be suppressed and which has high adhesion between the resin composition and the metal surface and the resin surface.

The film-forming substrate of the present embodiment can be used, for example, as a printed wiring board in which a solder resist film as a resin composition is formed between metal conductors serving as metal surfaces. In addition, the film-forming substrate can be used, for example, for various electronic and electrical devices, medical devices, vehicle-mounted devices, automobile parts, and parts for marine equipment.

The surface treatment agent, the method for producing a film-forming substrate, and the film-forming substrate according to the present embodiment have been described above; however, the embodiments disclosed herein are to be considered in all respects as illustrative and not restrictive. The scope of the present invention is indicated not by the above description but by the claims, and all modifications within the meaning and scope equivalent to the claims are intended to be included.

### Examples

Next, Examples of the present invention will be described together with Comparative Examples. It should be noted that the present invention is not to be construed as being limited to the following Examples.

### "Test 1"

### <Preparation of Test Substrate>

A plated plate (manufactured by AIKOKIKI MFG. CO., LTD.: 12 cm × 12 cm) having a copper plating layer with a thickness of 35 µm was prepared as a test substrate.

Furthermore, the test substrate was sprayed on one side using an organic acid-based micro-etching agent (manufactured by MEC COMPANY LTD., CZ series) under conditions of a temperature of 25°C and a spray pressure of 0.1 MPa, and etched by adjusting the etching time so that an etching amount of 1.0 µm was achieved on the one side of the test substrate, and then washed with water. The surface that was washed with water was defined as a treated surface, thereby preparing a micro-etched substrate.

In addition, as a resin substrate, a copper-clad laminate material for a printed circuit (trade name: MCL-E-67, manufactured by Resonac Corporation) was cut to 12 cm × 12 cm to prepare a resin substrate having a resin surface (epoxy resin) as a treated surface.

### <Surface Treatment Agent>

Aqueous solutions of the respective amine compounds listed in Table 1 (temperature: 25°C, concentration: 0.1 mass%) were prepared, and surface treatment agents were prepared by adjusting the pH to the respective values listed in Table 1 using hydrochloric acid (35%) and an aqueous sodium hydroxide solution (24%).

The pH was measured using a pH/ION METER F-72 (manufactured by HORIBA, Ltd.).

A test substrate, a micro-etched substrate, and a resin substrate were used as one set, and the treated surfaces were treated with the respective surface treatment agents to obtain Examples 1 to 20.

The surface treatment was performed by immersing the treated surfaces of the respective substrates for the times listed in Table 1, and then washing with water and drying were performed.

The amine compounds used were as follows.
Oleylamine (manufactured by NOF Corporation, carbon number: 18/alkenylamine)
Aminononadecane (manufactured by Tokyo Chemical Industry Co., Ltd., carbon number: 19/alkylamine)
Behenylamine (manufactured by NOF Corporation, carbon number: 22/alkylamine)

### <Contact Angle Measurement 1>

For the surface-treated substrates described above, contact angles with respect to dipropylene glycol, a solder resist, and distilled water were measured.

The contact angle of each test substrate was measured by the sessile drop method described in JIS R3257 "Test method for wettability of substrate glass surfaces". As a measuring device, an automatic contact angle meter DM-501 manufactured by Kyowa Interface Science Co., Ltd. was used.

For measurement of the contact angle with respect to dipropylene glycol, dipropylene glycol (manufactured by KISHIDA CHEMICAL CO., LTD.) was used in place of distilled water described in JIS R3257.

For measurement of the contact angle with respect to the solder resist, a solder resist (manufactured by TAIYO HOLDINGS CO., LTD., product number IJSR-4000) was used in place of distilled water described in JIS R3257.

The results are shown in Table 1.

**[Table 1]**

| | | | | | | Contact angle (°) | | | Contact angle (*) | | | Contact angle | | |
|---|---|---|---|---|---|---|---|---|---|---|---|---|---|---|
| | | | | | | DPG | | | TAIYO HOLDINGS CO., LTD., JISR-4000 | | | DI water | | |
| | | | Type | Concentration (wt%) | pH | Test substrate | Etched substrate | Resin substrate | Test substrate | Etched substrate | Resin substrate | Test substrate | Etched substrate | Resin substrate |
| Comparative Example | 1 | Untreated | - | - | - | 25 | 19 | 30 | 22 | 16 | 28 | 73 | 19 | 105 |
| Example | 1 | Oleylamine | C18/alkenyl | 0.1 | 4 | 46 | 49 | 41 | 44 | 50 | 39 | 104 | 128 | 108 |
| Example | 2 | | | | 6 | 50 | 55 | 58 | 46 | 64 | 55 | 108 | - | 118 |
| Example | 3 | | | | 8 | 51 | 66 | 59 | 49 | 63 | 65 | 105 | 131 | 119 |
| Example | 4 | | | | 10 | 51 | 76 | 54 | 44 | 49 | 60 | 108 | 133 | 120 |
| Example | 5 | | | | 12 | 53 | 58 | 52 | 52 | 43 | 49 | 105 | 124 | 109 |
| Example | 6 | | | | 14 | 47 | 57 | 53 | 45 | 44 | 48 | 104 | 126 | 105 |
| Example | 8 | Aminononadecane Aminononadecane | C19/alkyl | 0.1 | 4 | 54 | 61 | 34 | 57 | 51 | 30 | 105 | 128 | 113 |
| Example | 9 | | | | 6 | 55 | 85 | 45 | 56 | 77 | 38 | 105 | 131 | 106 |
| Example | 10 | | | | 8 | 60 | 84 | 51 | 62 | 75 | 52 | 107 | 126 | 114 |
| Example | 11 | | | | 10 | 60 | 37 | 61 | 59 | 40 | 64 | 109 | 122 | 122 |
| Example | 12 | | | | 12 | 34 | 31 | 35 | 34 | 28 | 32 | 105 | 111 | 114 |
| Example | 13 | | | | 14 | 28 | 22 | 32 | 22 | 25 | 34 | 99 | 94 | 107 |
| Example | 15 | Behenylamine | C22/alkyl | 0.1 | 4 | 37 | 46 | 43 | 37 | 45 | 38 | 102 | 124 | 109 |
| Example | 16 | | | | 6 | 46 | 55 | 53 | 52 | 64 | 40 | 110 | 130 | 110 |
| Example | 17 | | | | 8 | 44 | 53 | 56 | 55 | 46 | 48 | 103 | 129 | 104 |
| Example | 18 | | | | 10 | 46 | 68 | 64 | 47 | 43 | 67 | 107 | 121 | 120 |
| Example | 19 | | | | 12 | 31 | 19 | 32 | 27 | 21 | 29 | 96 | 118 | 103 |
| Example | 20 | | | | 14 | 34 | 18 | 34 | 25 | 21 | 29 | 60 | 89 | 93 |

As shown in Table 1, in all of the Examples, as compared with untreated substrates as Comparative Examples, the contact angles of the test substrate, the etched substrate, and the resin substrate with respect to dipropylene glycol were increased and could be adjusted within a range of 35° or more and 100° or less. For aminononadecane and behenylamine, when the pH was 12 or more, the contact angle in some cases fell outside this range; however, by adjusting the pH to less than 10, the contact angle fell within the above range.

In addition, comparison of the measurement results of the contact angles with respect to dipropylene glycol and the solder resist shows that, when treatment was performed using the same amine compound at the same pH, a correlation was observed.

On the other hand, with respect to contact angles with respect to distilled water, no significant improvement in contact angle was observed for untreated substrates as Comparative Examples, particularly for the resin substrates, with any of the surface treatment agents. That is, it can be understood that no correlation is observed between the contact angle with respect to the solder resist and the contact angle with respect to distilled water.

### "Test 2"

Surface treatment agents were prepared in the same manner as in Test 1 using amine compounds that are alkylamines and alkenylamines having different carbon numbers. The pH was adjusted to 10.

The amine compounds used were as follows.
Oleylamine (manufactured by NOF Corporation, carbon number: 18/alkenylamine)
Aminononadecane (manufactured by Tokyo Chemical Industry Co., Ltd., carbon number: 19/alkylamine)
Behenylamine (manufactured by NOF Corporation, carbon number: 22/alkylamine)
Hexylamine (manufactured by Tokyo Chemical Industry Co., Ltd., carbon number: 6/alkylamine)
Octylamine (manufactured by KISHIDA CHEMICAL CO., LTD., carbon number: 8/alkylamine)
Dodecylamine (manufactured by KISHIDA CHEMICAL CO., LTD., carbon number: 12/alkylamine)
Tetradecylamine (manufactured by Tokyo Chemical Industry Co., Ltd., carbon number: 14/alkylamine)

As the test substrates, substrates identical to the etched substrate and the resin substrate used in Test 1 were used.

Each test substrate was surface-treated in the same manner as in Test 1, and the contact angle with respect to dipropylene glycol was measured in the same manner as in Test 1.

The results are shown in Table 2.

**[Table 2]**

| | | Amine compound | Number of carbon atoms | Etched substrate | Resin substrate |
|---|---|---|---|---|---|
| Comparative Example | 2 | Untreated | | 19 | 30 |
| Comparative Example | 3 | Hexylamine | 6 (alkylamine) | 28 | 31 |
| Comparative Example | 4 | Octylamine | 8 (alkylamine) | 41 | 31 |
| Comparative Example | 5 | Dodecylamine | 12 (alkylamine) | 57 | 32 |
| Comparative Example | 6 | Tetradecylamine | 14 (alkylamine) | 67 | 33 |
| Example | 21 | Oleylamine | 18 (alkenylamine) | 75 | 54 |
| Example | 22 | Aminononadecane | 19 (alkylamine) | 84 | 61 |
| Example | 23 | Behenylamine | 22 (alkylamine) | 64 | 64 |

As shown in Table 2, when alkylamines having smaller carbon numbers were used, although the contact angle of the etched substrate could be improved to some extent, the contact angle of the resin substrate could not be sufficiently improved.

### "Test 3"

As the resin substrate, instead of the copper-clad laminate material for printed circuits using an epoxy resin that was used in Tests 1 and 2, a polyimide resin plate (thickness: 0.04 mm, size: 40 mm × 40 mm, trade name: Kapton, manufactured by Du Pont-Toray Co., Ltd.) was used, treatment was performed in the same manner as in Test 1 using the surface treatment agents used in Test 2, and then, the contact angle with respect to dipropylene glycol was measured.

The results are shown in Table 3.

**[Table 3]**

| | | Amine compound (number of carbon atoms) | Contact angle (°) |
|---|---|---|---|
| Comparative Example | 7 | Untreated | 23 |
| Comparative Example | 8 | Hexylamine (6) | 31 |
| Comparative Example | 9 | Octylamine (8) | 32 |
| Comparative Example | 10 | Dodecylamine (12) | 34 |
| Comparative Example | 11 | Tetradecylamine (14) | 34 |
| Example | 24 | Oleylamine (18) | 36 |
| Example | 25 | Aminononadecane (19) | 48 |
| Example | 26 | Behenylamine (22) | 56 |

As shown in Table 3, the contact angle with respect to the polyimide resin could be improved as compared with the untreated case, and in all of the Examples, a contact angle of 35° or more was obtained.

### "Test 4"

A surface treatment agent using oleylamine, which is one of the amine compounds used in Test 1, was prepared. The pH was adjusted to 8.6. The oleylamine concentration was adjusted to six different concentrations ranging from 0.001 mass% to 1.2 mass%; the same etched substrate and resin substrate as those used in Test 1 were treated in the same manner as in Test 1, and the contact angle with respect to dipropylene glycol was measured.

The results are shown in Table 4.

**[Table 4]**

| | Contact angle | |
|---|---|---|
| Concentration (wt%) | Etched substrate | Resin substrate |
| Untreated | 19 | 30 |
| 1.2 | 69 | 43 |
| 0.3 | 76 | 54 |
| 0.03 | 65 | 45 |
| 0.006 | 58 | 38 |
| 0.003 | 57 | 35 |
| 0.001 | 26 | 37 |

As shown in Table 4, at all concentrations, the contact angle could be improved as compared with the untreated substrate.

### "Test 5"

### <Measurement of Bleeding Width>

Using the etched substrate and the resin substrate used in Test 1, the bleeding width of the solder resist was measured.

After each test substrate was treated in the same manner as in Test 1 using the respective amine compound solutions listed in Table 5, a solder resist as a resin composition (manufactured by TAIYO HOLDINGS CO., LTD., product number IJSR-4000) was applied by an inkjet-type solder resist coating apparatus (apparatus name: CPS6151, manufactured by MicroCraft K.K.) with a target line width of 100 µm, and after the application, final curing was performed. In each amine compound solution, when undissolved matter of the amine compound was visually observed after mixing, a commercially available solubilizing agent was added. After curing, each test substrate was photographed using an optical microscope (apparatus name: Digital Microscope VHS-5000, manufactured by KEYENCE Corporation), line widths at arbitrary five points on the photograph were measured, and an average value of the five points was calculated.

As controls, the same measurements were also performed for untreated substrates without surface treatment (the etched substrate and the resin substrate). The results are shown in Table 6.

**[Table 5]**

| | Example 27 | Example 28 | Example 29 | Comparative Example 12 |
|---|---|---|---|---|
| Oleylamine (C18) | 0.10% | - | - | - |
| Tetradecylamine (C14) | - | - | - | 0.10% |
| Aminononadecane (C19) | - | 0.10% | - | - |
| Behenylamine (C22) | - | - | 0.10% | - |
| pH | 8.6 | 8.0 | 10.0 | 7.4 |

**[Table 6]**

| | Untreated | Example 27 | Example 28 | Example 29 | Comparative Example 12 |
|---|---|---|---|---|---|
| | Printed line width (µm) | | | | |
| Etched substrate | 167 | 123 | 112 | 124 | 125 |
| Resin substrate | 151 | 106 | 109 | 103 | 149 |

As shown in Table 6, for the etched substrates, in both the Examples and the Comparative Examples, the line width was closer to the target line width of 100 µm as compared with the untreated substrates, that is, bleeding was suppressed. For the resin substrates, in the Examples, bleeding was suppressed as compared with the untreated substrates, whereas in the Comparative Examples, the bleeding was equivalent to that of the untreated substrates.

## Claims

1. A surface treatment agent for treating a substrate surface including a metal surface and a resin surface, the surface treatment agent comprising 0.001 mass% or more and 1.2 mass% or less of an amine compound that is at least one selected from the group consisting of an alkylamine having an alkyl group having 19 to 24 carbon atoms, an alkenylamine having an alkenyl group having 18 to 22 carbon atoms, and salts thereof.

2. The surface treatment agent according to claim 1, wherein the amine compound is at least one selected from the group consisting of aminononadecane, arachidylamine, henicosylamine, behenylamine, tricosylamine, tetracosylamine, and oleylamine.

3. The surface treatment agent according to claim 1 or 2, wherein the surface treatment agent has a pH of 4.0 or more and a pH of 14 or less.

4. A method for producing a film-forming substrate in which a film of a resin composition is formed on a substrate surface, the method comprising:
a surface treatment step of bringing a surface treatment agent into contact with a substrate surface including a metal surface and a resin surface to perform surface treatment so that contact angles of the metal surface and the resin surface with respect to dipropylene glycol are 35° or more and 100° or less; and
a film-forming step of forming a film of a resin composition on the surface-treated substrate surface by an inkjet method.

5. The method for producing a film-forming substrate according to claim 4, wherein the surface treatment agent contains 0.001 mass% or more and 1.2 mass% or less of an amine compound that is at least one selected from the group consisting of an alkylamine having an alkyl group having 19 to 24 carbon atoms, an alkenylamine having an alkenyl group having 18 to 22 carbon atoms, and salts thereof.

6. The method for producing a film-forming substrate according to claim 4 or 5, wherein, in the film-forming step, a film is formed by an inkjet method using a resin composition that is cured by heating, ultraviolet irradiation, or light irradiation.

7. The method for producing a film-forming substrate according to claim 4 or 5, further comprising, prior to the surface treatment step, an etching step of etching the substrate surface with a micro-etching agent.

8. The method for producing a film-forming substrate according to claim 7, wherein, in the etching step, the metal surface is etched so as to have a surface roughness (Ra) of 0.1 µm or more and 0.8 µm or less.

9. The method for producing a film-forming substrate according to claim 4 or 5, wherein the surface treatment agent has a pH of 4.0 or more and a pH of 14 or less.

10. A film-forming substrate comprising a substrate surface on which a film of a resin composition is formed,
wherein the substrate surface includes a metal surface and a resin surface,
contact angles of the metal surface and the resin surface with respect to dipropylene glycol are 35° or more and 100° or less, and
a surface roughness (Ra) of the metal surface is 0.1 µm or more and 0.8 µm or less.

11. The film-forming substrate according to claim 10, wherein the resin surface includes at least one resin selected from the group consisting of a polyimide resin, an epoxy resin, a polyethylene terephthalate resin, a polypropylene resin, a polyvinyl chloride resin, a polyolefin resin, a polyurethane resin, and a polyacetal resin.

12. The film-forming substrate according to claim 10 or 11, wherein the resin composition is cured by heating, ultraviolet irradiation, or light irradiation.
